# EUROPEAN PATENT APPLICATION

(11) **EP 2 421 050 A1**
(43) Date of publication of application: **22.02.2012**
(21) Application number: 10764101.1
(22) Date of filing: 14.04.2010
(51) Int. Cl.: H01L 31/0376

(54) **THIN FILM OF SOLAR BATTERY STRUCTURE, THIN FILM OF SOLAR BATTERY ARRAY AND MANUFACTURING METHOD THEREOF**

(30) Priority: 15.04.2009 US 212673 P; 05.03.2010 CN 201010120365
(71) Applicant: Sunovel (Suzhou) Technologies Limited, Suzhou, Jiangsu 215123 (CN)
(72) Inventor: ZHU, Huilong, Poughkeepsie New York 12603 (US); LUO, Zhijiong, Shanghai 201315 (CN); Yin, Haizhou, Tianxin District, Changsha Hunan 410007 (CN)
(74) Representative: Valkeiskangas, Tapio Lassi Paavali
(86) International application number: PCT/CN2010/071772
(87) International publication number: WO 2010/118688

(57) **Abstract**

The present invention proposes a thin-film solar cell structure, a method for manufacturing the same and a thin-film solar cell array. The method for manufacturing thin-film solar cell structures comprises: forming at least two first trenches through a first surface into said semiconductor substrate, forming at least one second trench through a second surface into said semiconductor substrate, said second trench located between two neighboring said first trenches; forming a first structure on sidewalls of each of said first trenches; forming a second structure on sidewalls of each of said second trench; and cutting or stretching said semiconductor substrate to form thin-film solar cell structures. The distance between the electrodes can be effectively shortened through the present invention such that the recombination rate between the electrons and the holes can be reduced and the bulk recombination current and the surface recombination current can be reduced to achieve the objective of improving power generation efficiency. The thin-film solar cell structure and the method for manufacturing the same proposed in the present invention can also save semiconductor material and reduce production cost.

## Description

### FIELD OF THE INVENTION

The present invention relates to the field of solar cell manufacturing, and more specifically, to a new, highly efficient and low-cost thin-film solar cell structure, array and a method for manufacturing the same.

### BACKGROUND OF THE INVENTION

A thin-film solar cell, just as its name implies, is a solar cell prepared from a thin film, which uses a very small amount of semiconductor material and thus makes it easy to reduce the cost thereof. Meanwhile, it is not only a highly efficient source of energy, but can also be used as a novel building coating material, which makes it easy to realize a perfect combination with architecture. As raw silicon materials continue to be in short supply on the global market, thin-film solar cells have become a new trend and a new focus in development of the global photovoltaic market. At present, there are three types of thin-film cells that have entered the phase of industrialized mass production, i.e. silicon-based thin-film solar cells, copper indium gallium selenide thin-film solar cells and cadmium telluride thin-film solar cells. Thanks to the small amount of material required, its simple processing and low energy consumption, the thin-film solar cell demonstrates its competitive edge in cost, and thus a relatively fast development thereof has been achieved.

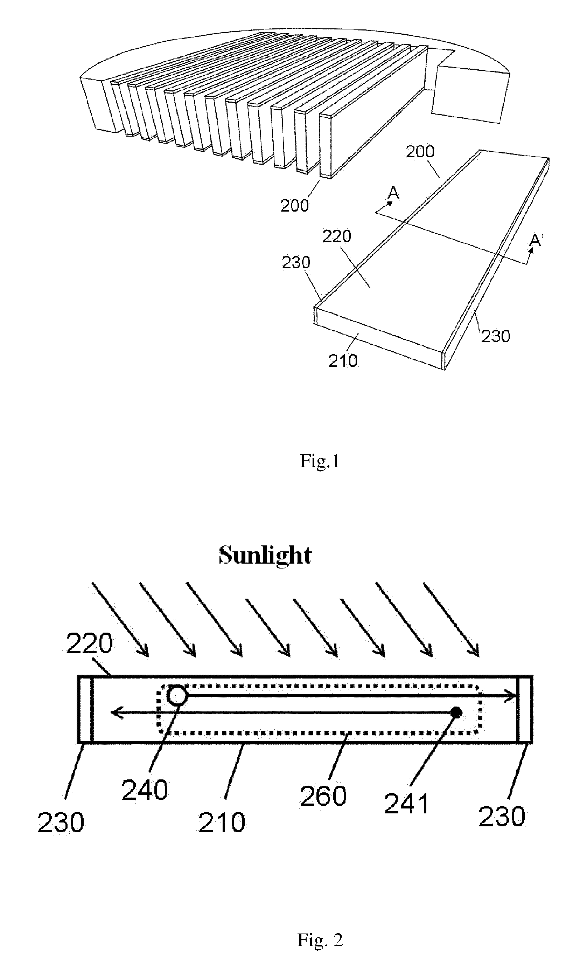

Figs. 1 and 2 are diagrams schematically showing a thin-film solar cell structure and conversion from solar energy to electric energy according to prior art. It can be seen from Fig. 1 that in the prior art, thin-film solar cell structures 200 are formed in the thickness direction of a wafer, wherein the electrodes 230 thereof are respectively provided on the sides of cell strip plates 210, regions between two respective electrodes 230 are light entry regions 220 and p-n junctions are within the cell strip plates 210. Fig. 2 is a cross-sectional view of one thin-film solar cell structure 200 as shown in Fig. 1 along AA' direction, and it can be seen that after the cell strip plate 210 takes in light, in the n-type semiconductor region and the p-type semiconductor region forming the p-n junction, a hole 240 in the n-type region moves towards the p-type region, while an electron 241 in the p-type region moves towards the n-type region such that a current is created from the n-type region to the p-type region. And then a potential difference is created across the p-n junction, thereby forming a power source.

As shown in Figs. 1 and 2, within the thin-film solar cell of such a structure, the electrodes 230 have a small area and a high resistance; and in order to increase the area for absorbing solar energy, the area of the light entry region 220 should be increased, while increasing a distance between the two electrodes 230, which is the same as the width of the light entry region 220 (usually greater than 0.5mm), may result in an increase in the volume of a recombination region 260 between the two electrodes 230 such that the bulk current and the surface recombination current are so great that power generation efficiency drops. Furthermore, the investment cost for the existing solar cell structure is relatively high, which hinders widespread applications of thin-film solar cells.

### SUMMARY OF THE INVENTION

One objective of the present invention lies in solving at least one of the aforesaid technical challenges, in particular, solving the challenge of relatively low power generation efficiency of a solar cell when the recombination region between two electrodes is increased.

The present invention relates, in one aspect, to a method for manufacturing thin-film solar cell structures, the method comprising: providing a semiconductor substrate having a first doping type, said semiconductor substrate having a first surface and a second surface facing respective sides of said semiconductor substrate; forming at least two first trenches through said first surface into said semiconductor substrate, and forming at least one second trench through said second surface into said semiconductor substrate, said second trench located between two neighboring said first trenches; forming a first structure on sidewalls of each of said at least two first trenches; forming a second structure on sidewalls of each of said at least one second trench; cutting or stretching said semiconductor substrate to form thin-film solar cell structures, wherein each portion of the semiconductor substrate located between neighboring said first and second trenches form one semiconductor strip plates of said thin-film solar cell structures, and wherein a light entry surface of said thin-film solar cell structures comprises said first structure, said second structure or a combination thereof.

The present invention further relates, in another aspect, to a thin-film solar cell structure, comprising: a semiconductor strip plate having a first doping type, said semiconductor strip plate including a third surface and a fourth surface opposite thereto; a first structure located on the third surface of said semiconductor strip plate, and a second structure located on the fourth surface, wherein said first structure, said second structure or combinations thereof constitutes a light entry surface of the solar cell structure; and sidewall spacers located on both sides of the semiconductor strip plate, wherein said sidewall spacers comprises an insulation layer.

The present invention relates, in still another aspect, to a thin-film solar cell array, comprising a plurality of said thin-film solar cell structures, wherein said thin-film solar cell structures are connected in parallel with each other.

A further aspect of the present invention relates to a thin-film solar cell array, comprising: a plurality of thin-film solar cell structures, each said solar cell structure comprising (a) a semiconductor strip plate having a first doping type, said semiconductor strip plate having a third surface and a fourth surface opposite thereto, (b) a first structure located on the third surface, and (c) a second structure located on the fourth surface, wherein said first structure comprises at least a first semiconductor layer having a second doping type and a first electrode layer, and wherein said second structure comprises at least a second electrode layer, said second doping type and first doping type being opposite to each other, and said first structure, said second structure or combinations thereof constituting a light entry surface of said one of said thin-film solar cell structures; and a plurality of bendable insulation layers, respectively, formed on two opposing surfaces (other than said third and fourth surfaces) of neighboring strip plates and connected to said neighboring strip plates; and a plurality of first conductive layers and second conductive layers matching said plurality of bendable insulation layers, wherein said first and second conductive layers are located on the sides of the insulation layers, said first conductive layers are coupled to the first electrode layers of two neighboring thin-film solar cell structures, and said second conductive layers are coupled to the second electrode layers of two neighboring thin-film solar cell structures.

Through the manufacturing method according to embodiments of the present invention, the effective areas of the electrodes are increased by effectively utilizing the thickness of the substrate (or wafer), and the electrodes and the light entry surface are provided on the same side so as to effectively reduce the recombination distance, shorten the distance between the electrodes, reduce the recombination current of carriers and improve power generation efficiency. The cell structure of the present invention forms an insulation layer on each of the sidewalls of the semiconductor strip plate. On one hand, it reduces recombination of the carriers on the sidewall portion and further improves power generation efficiency; and on the other hand, a conductive layer coupled with the electrodes may be further formed on the insulation layer and the conductive layer may be isolated so as to prevent a possible short circuit between two electrodes, realize parallel connection between the structures in the cell array through the conductive layer, reduce connection resistance and improve power generation efficiency.

The additional aspects and advantages of the present invention will be provided in the following description, among which some will be readily apparent from the following description, or understood by the realization of the present invention.

### BRIEF DESCRIPTION OF THE DRAWINGS

The above and/or additional aspects and advantages of the present invention will be readily apparent and more easily understood in the description below of exemplary embodiments in conjunction with the drawings, in which:

Fig. 1 is a schematic diagram illustrating a thin-film solar cell structure in the prior art;

Fig. 2 is a cross-sectional view of the thin-film solar cell structure along AA' direction as shown in Fig. 1;

Fig. 3 is a flowchart illustrating a method for manufacturing a thin-film solar cell structure according to an embodiment of the present invention;

Figs. 4-15 are cross-sectional views illustrating a thin-film solar cell structure according to an embodiment of the present invention at different manufacturing stages; and

Fig. 16 is a diagram illustrating the structure and working principle of a solar cell according to an embodiment of the present invention.

### DETAILED DESCRIPTION OF THE INVENTION

Various embodiments of the present invention are described in more details below with reference to the accompanying drawings, wherein like reference numerals used throughout the description represent like components or components having like functions. The embodiments described in conjunction with the drawings below are merely illustrative and used to explain the present invention alone, and cannot be construed as limiting the present invention.

One aspect of the present invention relates to forming electrodes on planes in the thickness direction of a substrate and positioning electrodes and light entry surface of a solar cell on the same surface so as to reduce recombination distance, shorten distance between electrodes, reduce bulk recombination current and improve power generation efficiency. Furthermore, in the structures according to embodiments of the present invention, insulation layers are provided on both sides of a cell strip plate, which can further reduce the recombination of carriers on the sides and improve power generation efficiency.

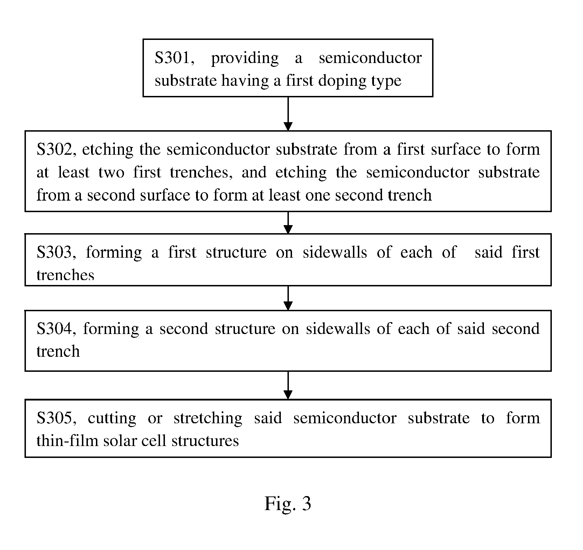

Fig. 3 is a flowchart illustrating a method for forming thin-film solar cell structures according to an embodiment of the present invention, which comprises the following steps:

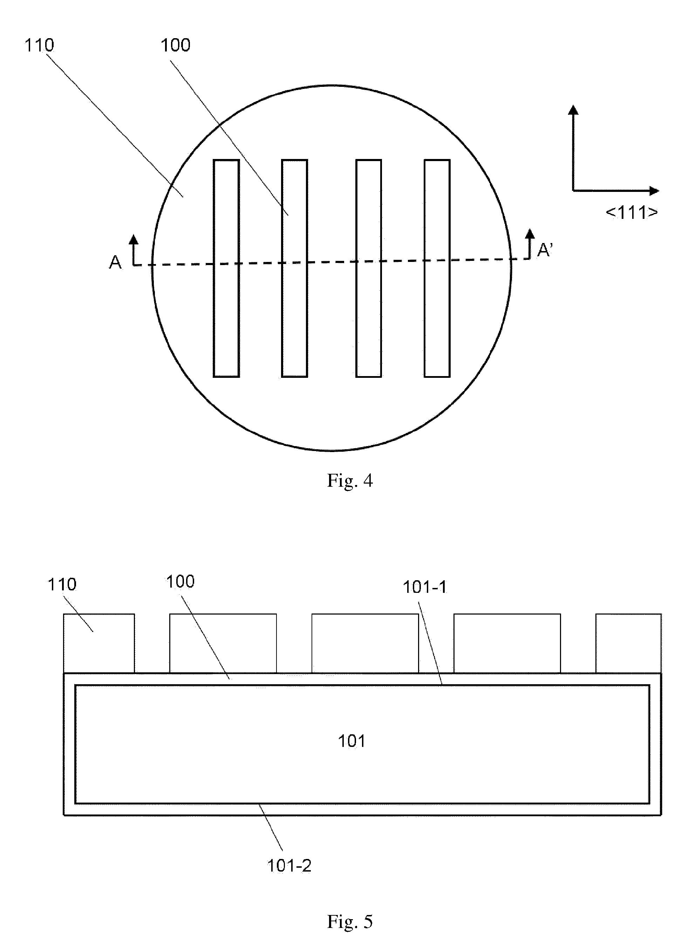

In step S301, a semiconductor substrate 101 is provided, wherein said semiconductor substrate 101 has a first doping type and comprises a first surface 101-1 and a second surface 101-2 opposite thereto (Figs. 4 and 5). In an embodiment of the present invention, the semiconductor substrate 101 is formed of monocrystalline Si, monocrystalline Ge, or monocrystalline GeSi, and preferably, the crystal orientation of the surfaces 101-1 and 101-2 is {110} or {112}, the crystal orientation of the plane formed when cutting in the thickness direction of the semiconductor substrate 101, perpendicular to the first and second surfaces, is {111}, and in another embodiment, the semiconductor substrate 101 may also comprise one or more materials selected from a group consisting of polycrystalline Si, polycrystalline Ge, polycrystalline SiGe, III-V and II-VI compound semiconductor. Said semiconductor substrate 101 has a first doping type, which can be a p-type doping or an n-type doping, and in an embodiment of the present invention, a p-type wafer or n-type wafer may be selected, and in another embodiment, the doping may be formed through desired doped configuration of the semiconductor substrate. The thickness of said semiconductor substrate may be 0.2-3mm.

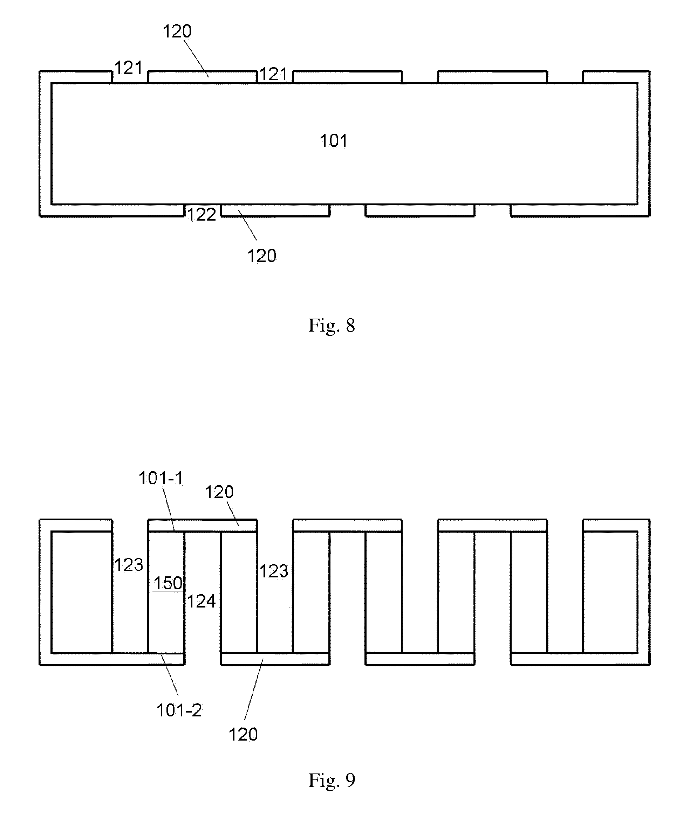

In step S302, the semiconductor substrate 101 is etched from said first surface 101-1 to form at least two first trenches 123, and (simultaneously or subsequently) the semiconductor substrate 101 is etched from said second surface 101-2 to form at least one second trench 124, each of which is located between two neighboring ones of said first trenches 123, as shown in Fig. 9. A series of exemplary processes for realizing step S302 according to an embodiment of the present invention are shown in Figs. 4-9.

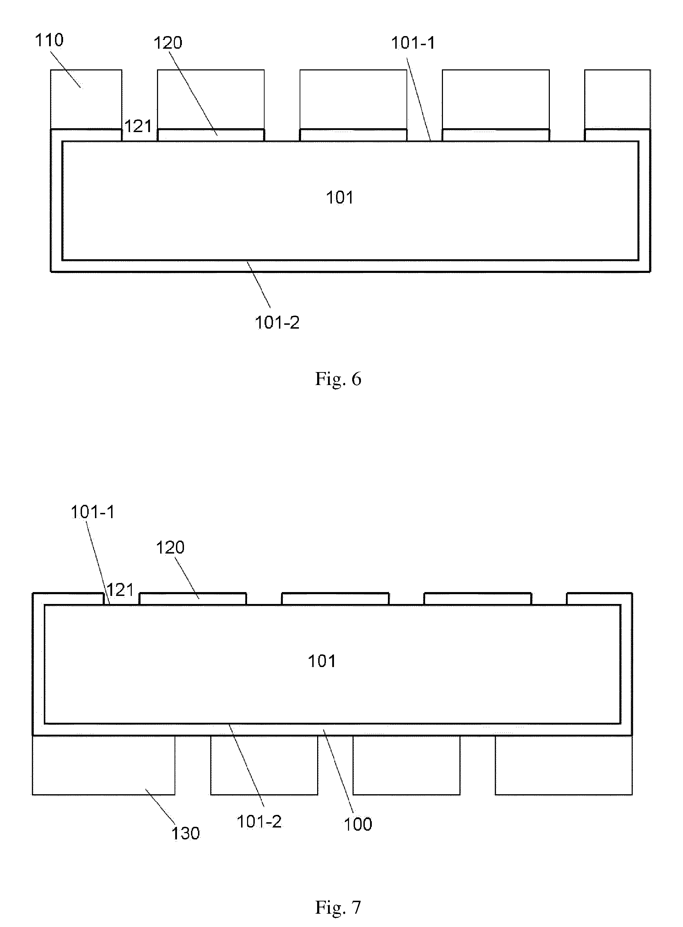

Specifically, first, as shown in Fig. 4 (top view) and Fig. 5 (AA' cross section view), an insulation layer 100, such as a nitride layer, is formed on the first surface 101-1, the second surface 101-2 and the sides of the semiconductor substrate 101, and in this embodiment said insulation layer 100 is nitride material having the function of an etch-stop layer and an insulation layer, and then a patterned photoresist 110 is formed on the insulation layer 100, wherein openings in the pattern of said photoresist 110 should correspond to the at least two first trenches to be etched. Preferably, said first trenches are equally spaced apart. Fig. 4 is a top view of a semiconductor substrate in an embodiment of the present invention with an insulation layer 100 and patterned photoresist 110 deposited, the crystal directions of the substrate is shown in the figure, and the patterned photoresist 110 may be formed through well known methods. Fig. 5 is a cross-sectional view of the substrate of the embodiment of the present invention with the insulation layer 100 and the patterned photoresist 110 deposited as shown in Fig. 4 along A-A' direction. Then the insulation layer 100 at the openings of the photoresist is etched away to expose the surface of the semiconductor substrate 101 to form at least two first openings 121 in the insulation layer 100, after which the patterned photoresist 110 is stripped off so that a patterned insulation layer 120 is formed, as shown in Fig. 6.

And then, as shown in Figs. 7 and 8, at least one second opening 122 corresponding to the second trench is formed in the insulation layer 100 on the second surface of the semiconductor substrate, each of the second openings 122 is located between two first openings 121. In a preferred embodiment of the present invention, each of the first openings 121 and each of the second openings 122 are equally spaced apart such that the lateral distances between the second trenches and the neighboring first trenches formed in subsequent steps are the same, which can effectively improve production efficiency and reduce cost. Fig. 7 is a schematic diagram of a patterned photoresist 130 formed with respect to the insulation layer 100 on the second surface after the photoresist on the first surface of the semiconductor substrate has been stripped off according to an embodiment of the present invention. Specifically, as shown in Fig. 8, the nitride layer 100 at the openings of the photoresist is etched away to expose the semiconductor substrate 101 to form second openings 122 in the nitride layer 100, and the patterned photoresist 130 is stripped off so that a patterned insulation layer 120 is formed.

And then, preferably, in order to reduce production time and cost, the patterned insulation layer 120 is used as a mask to etch the semiconductor substrate 101 from the first openings 121 and the second openings 122 simultaneously. Thereby first trenches 123 and second trenches 124 having opposite opening directions are formed such that the remaining portions of the semiconductor substrate 101 between the first trenches 123 and the second trenches 124 after the etching form a plurality of semiconductor strip plates 150 for thin-film solar cell structures. In an embodiment of the present invention, the thickness of said semiconductor strip plates 150 (measured horizontally between the trenches 123 and 124) is about 5-120µm, and the width of the strip plate 150 (measured vertically between the surfaces 101-1 and 101-2) is about 0.2-3mm. In other words, said thickness is the distance between surfaces corresponding to the sidewalls of two neighboring trenches 123 and 124 which share the same strip plate 150, and said width is the distance between the first surface 101-1 and the second surface 101-2, as shown in Fig. 9. Specifically, dry etching, such as RIE, or wet etching may be adopted to anisotropically etch the semiconductor substrate to form the first trenches 123 and the second trenches 124. Specifically, when said substrate is formed of monocrystalline materials, such as monocrystalline Si, monocrystalline Ge, monocrystalline SiGe or combinations thereof, wet etching, such as potassium hydroxide (KOH), tetramethylammonium hydroxide (TMAH) or ethylenediamine-pyrocatechol (EDP), may be adopted, and in the first and second trenches so formed, the crystal orientation of the sidewall surfaces thereof is {111}. The distance between the first trenches 123 and the neighboring second trenches 124 (i.e. the width of the portions of the semiconductor substrate 101 in the horizontal direction) determines the thickness of the thin-film solar cell structures, and thus the thickness of the thin-film solar cell structures is controlled by lithography. In an embodiment of the present invention, the thickness of the thin-film solar cell structures is about 10-120 microns. Furthermore, in some embodiments of the present invention, there is no need to remove the insulation layer 120 after etching the first and second trenches.

In some embodiments of the present invention, the depths of the first trench 123 and the second trench 124 may be smaller than or equal to the thickness of the semiconductor substrate 101. For instance, according to one embodiment of the present invention, it may be sufficient to etch only a portion of the semiconductor substrate (i.e., without etching through the substrate), such that the bottoms of the first trench 123 and the second trench 124 do not contact the insulation layer 120.

The aforesaid method for forming the first trench 123 and the second trench 124 is just one embodiment of the present invention. Without deviating from the spirit or scope of the present invention, those of ordinary skill in the art may also choose other well-known methods to achieve the same effect as the present invention.

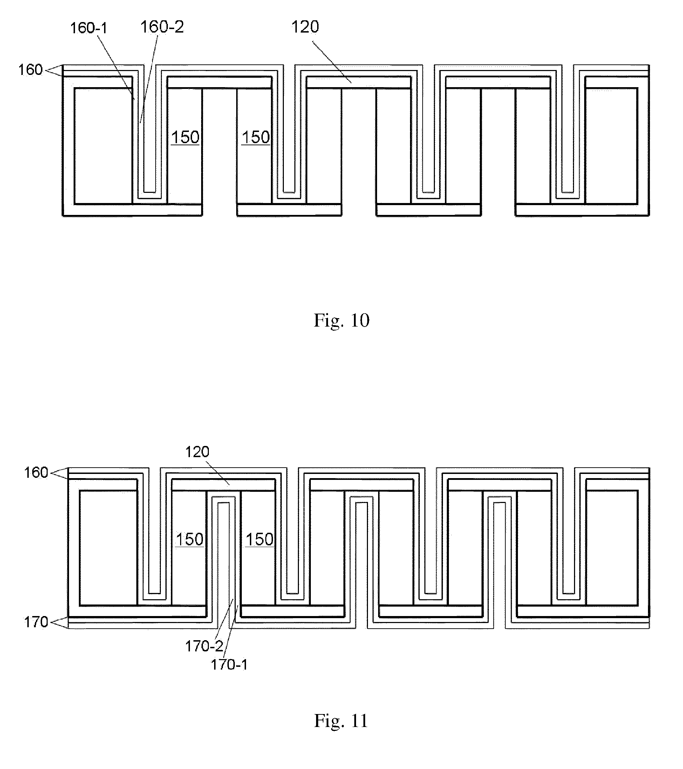

In step S303, a first structure 160 is formed on sidewalls of each of the first trenches, as shown in Fig. 10. Said first structure 160 may be a multilayer structure, and in an embodiment of the present invention, the first structure 160 comprises a first semiconductor layer 160-1 and a first electrode layer 160-2, said first semiconductor layer having a second doping type which is opposite to the first doping type. For example, when the first doping type is p-type, the second doping type may be n-type, and when the first doping type is n-type, the second doping type may be p-type. Said first semiconductor layer 160-1 of the second doping type may be formed by a dopant diffusion process or by a deposition process of semiconductor material having the desired second doping type, and a diffusion process may be further performed. In the present embodiment, said first semiconductor layer 160-1 may comprise one or more materials selected from a group consisting of amorphous silicon (a-Si), polycrystalline Si (poly-Si) and monocrystalline Si. Specifically, said first structure 160 may also cover entire first trenches 123.

In another embodiment of the present invention, a first intrinsic amorphous silicon layer (i-a-Si) may also be formed on sidewalls of each of said first trench 123 before forming the first semiconductor layer 160-1. In an embodiment of the present invention, the first intrinsic amorphous silicon layer may be a non-doped amorphous silicon layer with a thickness of about 1-10nm. In the present embodiment, the first semiconductor layer 160-1 is an amorphous silicon (a-Si) layer having the second doping type, with a thickness of about 10-50nm.

After the first semiconductor layer 160-1 is formed, a first electrode layer 160-2 is formed thereon. As a preferred embodiment of the present invention, TCO (Transparent Conductive Oxide) is deposited to form the first electrode layer 160-2 so as to reduce resistance and increase the power generation efficiency of the cell. As a preferred embodiment of the present invention, the temperature is controlled at below 550 °C during deposition. As a preferred embodiment of the present invention, TCO may be SnO₂ or ZnO, and in other embodiments, TCO may also comprise one or more materials selected from a group consisting of In₂O₃, ITO, CdO, Cd₂SnO₄, FTO and AZO.

In step S304, a second structure 170 is formed on sidewalls of each of the second trench 214, as shown in Fig. 11. Said second structure 170 may be a single layer or multilayer structure. In an embodiment of the present invention, said second structure 170 is a single-layer structure, and it comprises a second electrode 170-2, which may be formed by covering the second trench.

In another embodiment of the present invention, said second structure 170 is a multilayer structure, and the second structure 170 may comprise a second semiconductor layer 170-1 having the first doping type and a second electrode layer 170-2. Said second semiconductor layer 170-1 may be formed by a dopant diffusion process or by a deposition process of semiconductor material having the first doping type, and a diffusion process may be further performed. In the present embodiment, said second semiconductor layer 170-1 may comprise one or more materials selected from a group consisting of amorphous silicon (a-Si), polycrystalline Si (poly-Si) and monocrystalline Si. Specifically, said second structure 170 may also be formed by covering the entire second trench 124.

In another embodiment of the present invention, a second intrinsic amorphous silicon layer (i-a-Si) may be formed on sidewalls of each of said second trench 124 before forming the second semiconductor layer 170-1, wherein the second intrinsic amorphous silicon layer may be a non-doped amorphous silicon layer with a thickness of about 1-10nm. The second semiconductor layer 170-1 is an amorphous silicon (a-Si) layer having the first doping type, with a thickness of about 10-50nm.

After the second semiconductor layer 170-1 is formed, a second electrode layer 170-2 is formed thereon. Similarly, the second electrode layer 170-2 may be formed of any conductive materials, such as metallic materials, and as a preferred embodiment of the present invention, TCO (Transparent Conductive Oxide) is deposited to form the second electrode layer 170-2 so as to reduce resistance and increase the power generation efficiency of the cell. As a preferred embodiment of the present invention, the temperature is controlled at below 550 °C during deposition. TCO may be SnO₂ or ZnO, and in the other embodiments, TCO may also be In₂O₃, ITO, CdO, Cd₂SnO₄, FTO, AZO or combinations thereof.

In step S305, said semiconductor substrate is cut or stretched along said first and second trenches to form thin-film solar cell structures, wherein each of the portions of the semiconductor substrate between the first and second trenches forms the semiconductor strip plate of one of said thin-film solar cell structures. Said first structure, said second structure or combinations thereof constitutes a light entry surface of said one of the thin-film solar cell structures.

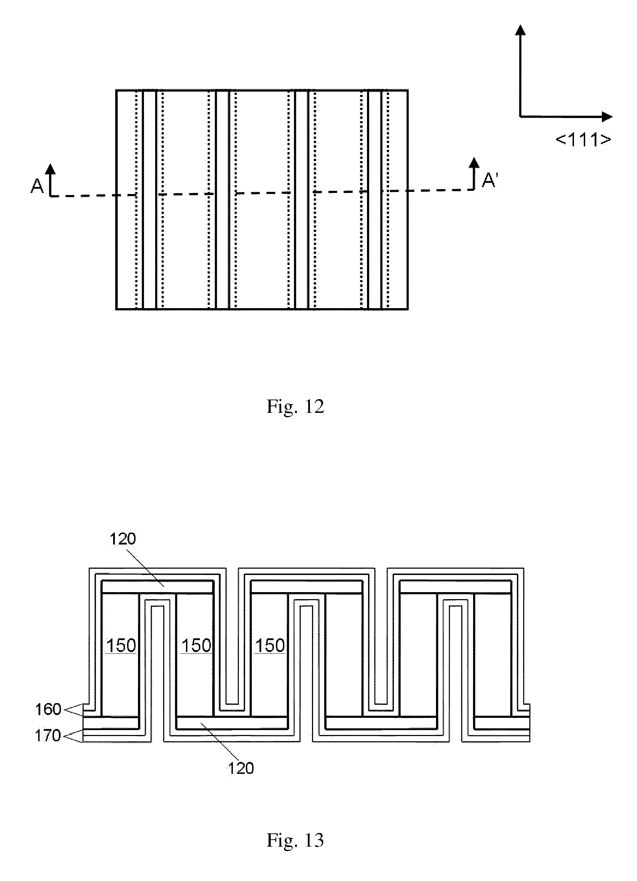

First, a peripheral area of the substrate is cut by a laser beam or other cutting tools. Fig. 12 is a top view of an embodiment of the present invention after the peripheral area of the substrate is cut, and Fig. 13 is a cross-sectional view of an embodiment of the present invention after the peripheral area of the substrate is cut.

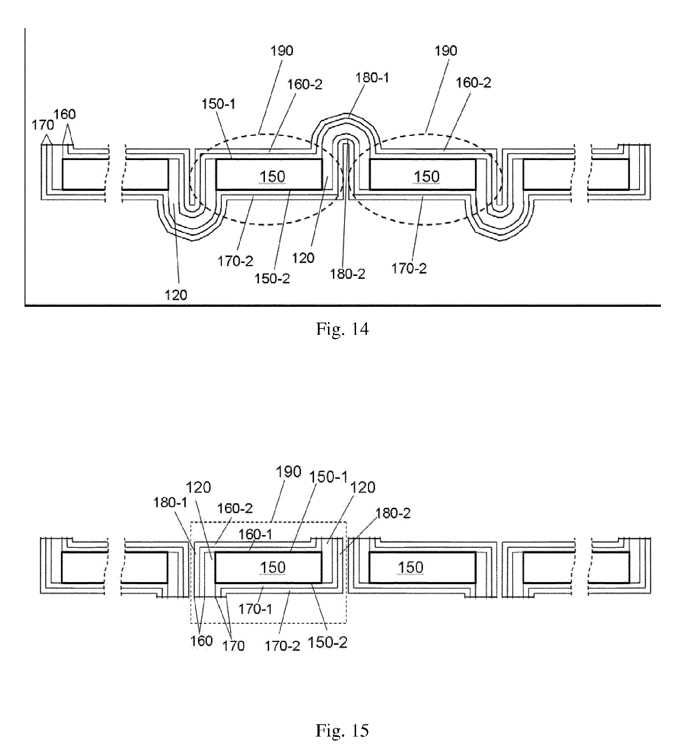

Then, said semiconductor substrate is cut or stretched from said first and second trenches to form a plurality of thin-film solar cell structures, wherein a portion of the first trench covered by the first structure forms a first structure of each of said thin-film solar cell structures, and a portion of the second trench covered by the second structure forms a second structure of each of said thin-film solar cell structures. Said first structure, said second structure or a combination thereof constitutes a light entry surface of each of said solar cell structures. Fig. 14 shows a schematic view (along A-A' cross section) of an entire array of thin-film solar cells 190 formed after stretching, and the curvatures of the insulation layers between neighboring solar cell structures so formed are opposite to each other. Fig. 15 shows a schematic view (along A-A' cross section) of an entire array of thin-film solar cells 190 formed by connection after cutting.

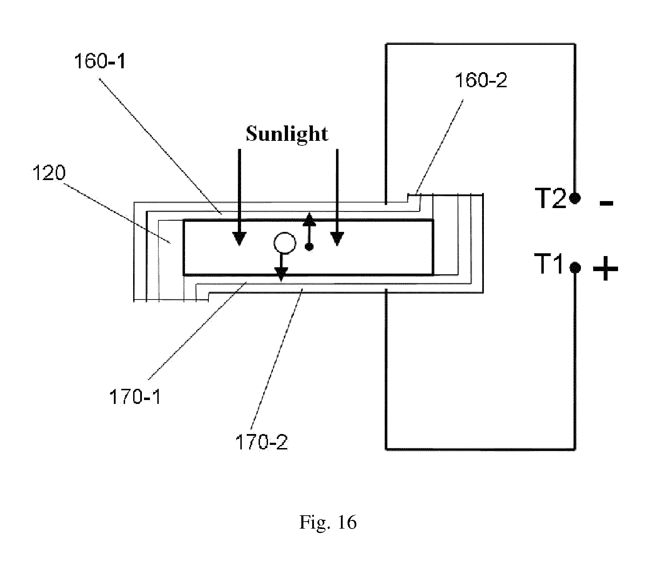

Fig. 16 shows the structure and working principle of a solar cell formed through the aforesaid steps. When sunlight illuminates the solar cell, electrons and holes are generated in the silicon or the semiconductor strip plate 150, and the electrons and holes are separated by the p-n junction electric field and are diffused to terminals T1 and T2, respectively. A voltage of from about 0.3 to 0.8V is formed between terminals T1 and T2 to realize the conversion from solar energy to electric energy. Sunlight usually enters the thin-film solar cell structure through the first structure 160; however, it may be chosen that sunlight enters through the second structure 170 if the thickness of the thin-film solar cell structure is small enough. The thickness of the thin-film solar cell structure formed by said method is determined by the distance between neighboring first and second trenches (Fig. 9), that can be controlled by lithography. A very small thickness, for instance, 5µm, can be easily achieved by well-known lithography techniques. Meanwhile, said thickness also determines the distance between the first and second structures. Furthermore, the width of the thin-film solar cell structure formed by said method is determined by the depth of the trenches, and the maximum depth may be the thickness of said semiconductor substrate (Fig. 9). Compared with the prior art as shown in Fig. 1, the distance between the first and second structures of the thin-film solar cell structure formed by the present method is determined by the thickness of the thin-film solar cell structure, instead of the width, and thus the distance between the first and second structures can be significantly shortened. Furthermore, wide thin-film solar cell structure can also be realized using thick semiconductor substrate (such as 1-3mm) by the present method, while not increasing the distance between the first and second structures and thus not affecting power generation efficiency. Compared with a thin semiconductor substrate, if a thick semiconductor substrate is adopted, the unit area cost of the thin-film solar cell structure can be further reduced by the present method.

Solar cells manufactured by the method of the aforesaid embodiments can effectively reduce the production cost of the solar cells. Furthermore, the solar cell structure proposed in the present invention can also effectively reduce recombination distance, shorten the distance between the electrodes, reduce bulk recombination current and improve power generation efficiency. Furthermore, the present invention can increase the effective area of the electrodes and reduce series resistance. Meanwhile, since an insulation layer is provided on the sidewalls of the thin-film solar cell of the present invention, recombination of the electrons and holes on the sides is effectively reduced and power generation efficiency is further improved.

Furthermore, a new thin-film solar cell structure may be formed by cutting the cell structure formed, as shown in Fig. 15. Said thin-film solar cell structure comprises: a semiconductor strip plate 150, said semiconductor strip plate 150 having a first doping type and including a third surface 150-1 and a fourth surface 150-2 opposite thereto; a first structure 160 located on the third surface 150-1 of said semiconductor strip plate, and a second structure 170 located on the fourth surface 150-2, wherein said first structure 160, said second structure 170 or a combination thereof constitutes the light entry surface of the solar cell structure; and sidewall spacers provided on both sides of the semiconductor strip plate 150 and between said third surface 150-1 and fourth surface 150-2. In an embodiment, said sidewall spacers comprise an insulation layer 120. Preferably, said sidewall spacers may further comprise conductive layers 180-1 and 180-2 on the insulation layer 120, respectively, wherein said conductive layer 180-1 is coupled to the first electrode layer 160-2, and said conductive layer 180-2 is coupled to the second electrode layer 170-2, said conductive layer 180-1 and said first electrode 160-2 may be formed as an integral structure, and said conductive layer 180-2 and said second electrode 170-2 may also be formed as an integral structure and be formed from TCO materials. The materials of said insulation layer 120 include silicon nitride, silicon oxide, silicon oxynitride, TiO₂, HfO₂, ZrO₂, Al₂O₃ or combinations thereof.

In an embodiment of the present invention, said semiconductor strip plate is formed of monocrystalline Si, monocrystalline Ge, or monocrystalline SiGe. Preferably, the crystal orientation of said third and fourth surfaces is {111}, and the crystal orientation of surfaces perpendicular to the third surface is {110} or {112}. In other embodiments, said semiconductor strip plate may also comprise one or more materials selected from a group consisting of polycrystalline Si, polycrystalline Ge, polycrystalline SiGe, III-V and II-VI compound semiconductor. Said semiconductor strip plate has a first doping type, and said first doping type may be p-type doping or n-type doping. The thickness of said semiconductor strip plate between the third and fourth surfaces is about 5-120µm, and the width thereof is about 0.2-3mm.

Said first structure 160 may be a multilayer structure, and in an embodiment of the present invention, the first structure 160 comprises a first semiconductor layer 160-1 having a second doping type and a first electrode layer 160-2, and said first semiconductor layer 160-1 may comprise one or more materials selected from a group consisting of amorphous silicon (a-Si), polycrystalline Si (poly-Si) and monocrystalline Si. In another embodiment, the first structure 160 comprises a first semiconductor layer 160-1 having a second doping type, a first electrode layer 160-2 and a first intrinsic amorphous silicon layer (i-a-Si) located between the first semiconductor layer 160-1 and the semiconductor strip plate 150, said first semiconductor layer 160-1 is an amorphous silicon (a-Si) layer with a thickness of about 10-50nm, and the thickness of said first intrinsic amorphous silicon layer is about 1-10nm.

Said second structure 170 may be a single-layer or multilayer structure. In an embodiment of the present invention, said second structure 170 is a single-layer structure, comprising a second electrode layer 170-2. In another embodiment of the present invention, said second structure 170 is a multilayer structure and comprises a second semiconductor layer 170-1 having the first doping type and a second electrode layer 170-2, wherein said second semiconductor layer 170-1 may comprise one or more materials selected from a group consisting of amorphous silicon (a-Si), polycrystalline Si (poly-Si) and monocrystalline Si. In another embodiment, the second structure 170 comprises a second semiconductor layer 170-1 having the first doping type, a second electrode layer 170-2 and a second intrinsic amorphous silicon layer (i-a-Si) located between the second semiconductor layer 170-1 and the semiconductor strip plate 150, wherein said second semiconductor layer 170-1 is an amorphous silicon (a-Si) layer with a thickness of about 10-50nm, and the thickness of said second intrinsic amorphous silicon layer is about 1-10nm.

The aforesaid first and second electrode layers are preferably formed by TCO materials, wherein said TCO materials may be selected from a group consisted of SnO₂, In₂O₃, ZnO, ITO, CdO, Cd₂SnO₄, FTO and AZO.

Said first doping type and said second doping type are opposite doping types: when the first doping type is p-type, the second doping type is n-type, and when the first doping type is n-type, the second doping type is p-type.

The thin-film solar cell structure of the present invention is described above according to another embodiment of the present invention, wherein said thin-film solar cell structure comprises an insulation layer, which not only isolates the first and second electrode layers to prevent a short circuit, but also reduces recombination of the photo-excited carriers on the sides so as to improve power generation efficiency. In a preferred embodiment, a conductive layer is further provided on said insulation layer. Said conductive layer and the electrodes are formed as an integral structure, and said conductive layer does not block the light entry surface. Therefore, the conductivity of the electrodes can be effectively enhanced, and the resistance of the thin-film solar cell can be reduced to improve power generation efficiency.

Furthermore, in an embodiment of the present invention, a thin-film solar cell array is formed by combining the aforesaid thin-film solar cells, (Fig. 14). Said thin-film solar cell array comprises a plurality of said thin-film solar cell structures 190, wherein said thin-film solar cell structures are connected in parallel with each other, as shown in Fig. 14. A plurality of said thin-film solar cell structures 190 can be formed by said method, and then the first electrode layers 160-2 of two neighboring ones of said thin-film solar cell structures 190 are coupled by the conductive layer 180-1, and said second electrode layers 170-2 are coupled by the conductive layer 180-2. In such a way, a thin-film solar cell array is formed by connecting a plurality of thin-film solar cells in parallel, wherein said conductive layers 180-1 and 180-2 are made of any conductive materials, and in an embodiment of the present invention, the conductive layers 180-1 and 180-2 may be formed when forming the first and second electrode layers, i.e., the conductive layer 180-1 and the first electrode layer 160-2 are formed as an integral structure, and the conductive layer 180-2 and the second electrode layer 170-2 are formed as an integral structure. In other embodiments, they may be formed separately.

In the thin-film solar cell array formed by connecting said thin-film solar cell structures, there are insulation layers, which not only isolate the first and second electrode layers to prevent a short circuit, but also reduce recombination of the photo-excited carriers on the sides so as to improve power generation efficiency. In a preferred embodiment, a conductive layer is further provided on each of said insulation layers, and said conductive layer and a respective one of the electrodes are formed as an integral structure. Said conductive layer does not block the light entry surface. The conductivity of the electrodes can be effectively enhanced, and thus the resistance for connecting the thin-film solar cells can be reduced to further improve power generation efficiency.

Furthermore, a new thin-film solar cell array can be formed by stretching the thin-film solar cell structures so formed, as shown in Fig. 14. Each of said thin-film solar cell structures 190 comprises a semiconductor strip plate 150 having the first doping type and including a third surface 150-1 and a fourth surface 150-2 opposite thereto, and a first structure 160 located on the third surface 150-1 and a second structure 170 located on the fourth surface 150-2, wherein said first structure 150 comprises a first semiconductor layer 160-1 having the second doping type and a first electrode layer 160-2, and said second structure 170 comprises a second electrode layer 170-2, wherein the second doping type and the first doping type are opposite to each other, and each of said first structures 160, said second structures 170 or a combination thereof constitutes a light entry surface of one of said thin-film solar cell structure 190.

Said solar cell array further comprises a plurality of bendable insulation layers 120, formed on two opposing surfaces of neighboring semiconductor strip plates 150 and coupled to said neighboring strip plates 150. The curvatures of neighboring said bendable insulation layers 120 are opposite to each other. Plurality of first conductive layers 180-1 and second conductive layers 180-2, matching said plurality of bendable insulation layers, are located on both sides of the insulation layers 120. Said first conductive layers 180-1 are coupled to first electrode layers 160-2 of two neighboring thin-film solar cell structures 190, and said second conductive layers 180-2 are coupled to the second electrode layers 170-2 of two neighboring thin-film solar cell structures 190.

Said solar cell array may be formed by stretching in step S305 said thin-film solar cell structures formed as set forth in aforesaid embodiment. Said semiconductor strip plates 150 will substantially be on the same horizontal plane after stretching, while the insulation layers will become bent and connect two neighboring strip plates 150 from two opposing surfaces thereof. The connection may also be realized by other method. In a preferred embodiment, the first conductive layer 180-1 and the second conductive layer 180-1 may be formed when forming the first and second electrode layers, i.e., the first conductive layer and the first electrode layer are formed as an integral structure, and the second conductive layer and the second electrode layer are formed as an integral structure. The first and second electrode layers are preferably formed by TCO materials, wherein said TCO materials may be selected from a group consisted of SnO₂, In₂O₃, ZnO, ITO, CdO, Cd₂SnO₄, FTO and AZO.

In an embodiment of said solar cell array in the present invention, said semiconductor strip plate comprises one or more materials selected from a group consisting of monocrystalline Si, monocrystalline Ge, monocrystalline SiGe, polycrystalline Si, polycrystalline Ge, polycrystalline SiGe, III-V and II-VI compound semiconductor. In a preferred embodiment, when said semiconductor strip plate is formed of monocrystalline Si, monocrystalline Ge, or monocrystalline SiGe, the crystal orientation of the third surface of said semiconductor strip plate may be {111}, and the crystal orientation of the surface perpendicular to the third surface is {110} or {112}. The thickness of said semiconductor strip plate between the third and fourth surfaces is about 5-120µm, and the width thereof is about 0.2-3mm, wherein said thickness is the distance between the third and fourth surfaces, and said width is the distance between the inner sides of two bendable insulation layers of the semiconductor strip plate.

Said first structure 160 may be a multilayer structure. In an embodiment of the present invention, the first structure 160 comprises a first semiconductor layer 160-1 having the second doping type and a first electrode layer 160-2. Said first semiconductor layer 160-1 may comprise one or more materials selected from a group consisting of amorphous silicon (a-Si), polycrystalline Si (poly-Si) and monocrystalline Si. In another embodiment, the first structure 160 comprises a first semiconductor layer 160-1 having the second doping type, a first electrode layer 160-2 and a first intrinsic amorphous silicon layer (i-a-Si) located between the first semiconductor layer 160-1 and the semiconductor strip plate 150. Said first semiconductor layer 160-1 is an amorphous silicon (a-Si) layer with a thickness of about 10-50nm, and the thickness of said first intrinsic amorphous silicon layer is about 1-10nm.

Said second structure 170 may be a single-layer or multilayer structure. In an embodiment of the present invention, said second structure 170 is a single-layer structure, comprising a second electrode layer 170-2. In another embodiment of the present invention, said second structure 170 is a multilayer structure, comprising a second semiconductor layer 170-1 having the first doping type and a second electrode layer 170-2, wherein said second semiconductor layer 170-1 may comprise one or more materials selected from a group consisting of amorphous silicon (a-Si), polycrystalline Si (poly-Si) and monocrystalline Si. In another embodiment, the second structure 170 comprises a second semiconductor layer 170-1 having the first doping type, a second electrode layer 170-2 and a second intrinsic amorphous silicon layer (i-a-Si) located between the second semiconductor layer 170-1 and the semiconductor strip plate 150, wherein said second semiconductor layer 170-1 is an amorphous silicon (a-Si) layer with a thickness of about 10-50nm, and the thickness of said second intrinsic amorphous silicon layer is about 1-10nm.

Said second doping type and said first doping type are opposite doping types: when the first doping type is p-type, the second doping type is n-type, and when the first doping type is n-type, the second doping type is p-type.

The aforesaid solar cell array has bendable insulation layers provided on the sidewalls of the strip plates, which can reduce recombination of the photo-excited carriers on the sidewalls of the strip plates and improve power generation efficiency. Said bendable insulation layers can also isolate the first and second electrode layers to prevent failure caused by electrode short circuit. Furthermore, conductive layers are formed on the insulation layers on the sidewall portions of the strip plates, which can reduce the resistance for connecting the cell structures, enhance conductivity of the cell array and further improve power generation efficiency.

Although various embodiments of the present invention have been shown and described, to those of ordinary skill in the art, it is understood that any variation, amendment, replacement and modification can be made without departing from the principle and spirit of the present invention, and the scope of the present invention is equivalently defined by the appended claims.

## Claims

1. A method for manufacturing thin-film solar cell structures, comprising:
A. providing a semiconductor substrate having a first doping type, said semiconductor substrate having a first surface and a second surface facing respective sides of said semiconductor substrate;
B. forming at least two first trenches through said first surface into said semiconductor substrate, and forming at least one second trench through said second surface into said semiconductor substrate, said second trench located between two neighboring said first trenches;
C. forming a first structure on sidewalls of each of said at least two first trenches;
D. forming a second structure on sidewalls of each of said at least one second trench; and
E. cutting or stretching said semiconductor substrate to form thin-film solar cell structures, wherein each portion of the semiconductor substrate located between neighboring said first and second trenches form one semiconductor strip plates of said thin-film solar cell structures, and wherein a light entry surface of said thin-film solar cell structures comprises said first structure, said second structure or a combination thereof.

2. The method according to claim 1, wherein said step B comprises:
forming an insulation layer on said first and second surfaces; etching the insulation layer on said first surface to form at least two first openings exposing the first surface, and etching the insulation layer on said second surface to form at least one second opening exposing the second surface, each of the second openings being located between two neighboring said first openings, thereby patterning the insulation layer; and etching said semiconductor substrate using the patterned insulation layer as a mask to form said first trenches and said second trenches.

3. The method according to claim 2, wherein said first openings and said second openings are equally spaced apart.

4. The method according to claim 1, wherein said step C comprises:
forming a first semiconductor layer having a second doping type on the sidewalls of said first trenches, and forming a first electrode layer on said first semiconductor layer, wherein said second doping type is opposite to the first doping type.

5. The method according to claim 4, wherein the step of forming the first semiconductor layer comprises: forming the first semiconductor layer having the second doping type on the sidewalls of said first trenches by diffusion.

6. The method according to claim 4, wherein the step of forming the first semiconductor layer comprises: depositing the first semiconductor layer having the second doping type on the sidewalls of said first trenches.

7. The method according to claim 6, further comprising: performing dopant diffusion annealing after depositing said first semiconductor layer.

8. The method according to claim 4, further comprising: forming a first intrinsic amorphous silicon layer (i-a-Si) on the sidewalls of said first trenches before forming said first semiconductor layer.

9. The method according to claim 1, wherein said step D comprises:
forming a second electrode layer on the sidewalls of said second trench.

10. The method according to claim 1, wherein said step D comprises:
forming a second semiconductor layer having the first doping type on the sidewalls of said second trench and forming a second electrode layer on said second semiconductor layer.

11. The method according to claim 10, wherein the step of forming the second semiconductor layer comprises: forming the second semiconductor layer having the first doping type on the sidewalls of said second trench by diffusion.

12. The method according to claim 10, wherein the step of forming the second semiconductor layer comprises: depositing the second semiconductor layer having the first doping type on the sidewalls of said second trench.

13. The method according to claim 12, further comprising: performing dopant diffusion annealing after depositing said second semiconductor layer.

14. The method according to claim 10, further comprising: forming a second intrinsic amorphous silicon layer (i-a-Si) on the sidewalls of said second trench before forming said second semiconductor layer.

15. The method according to claim 6 or 12, wherein said first and second semiconductor layers comprise one or more materials selected from a group consisting of amorphous silicon (a-Si), polycrystalline Si (poly-Si) and monocrystalline Si.

16. The method according to claim 8 or 14, wherein said first and second semiconductor layers are formed of amorphous silicon (a-Si).

17. The method according to claim 16, wherein the thickness of said first and second semiconductor layers is about 10-50nm.

18. The method according to claim 16, wherein the thickness of said first and second intrinsic amorphous silicon layers is about 1-10nm.

19. The method according to any one of claims 1 to 14, wherein said first and second electrode layers are formed by TCO materials, wherein said TCO materials are selected from a group consisted of SnO₂, In₂O₃, ZnO, ITO, CdO, Cd₂SnO₄, FTO and AZO.

20. The method according to any one of claims 1 to 14, wherein said second electrode layer is formed of metallic materials.

21. The method according to any one of claims 1 to 14, wherein the depth of said first and second trenches is smaller than or equal to the thickness of said semiconductor substrate.

22. The method according to any one of claims 1 to 14, wherein the thickness of said semiconductor strip plates is about 5-120µm, and the width thereof is about 0.2-3mm, wherein said thickness is the distance between surfaces corresponding to the sidewalls of neighboring trenches which belong to the same strip plate, and said width is the distance between said first surface and said second surface.

23. The method according to claim 1, wherein said semiconductor substrate comprises one or more materials selected from a group consisting of monocrystalline Si, monocrystalline Ge, monocrystalline SiGe, polycrystalline Si, polycrystalline Ge, polycrystalline SiGe, III-V and II-VI compound semiconductor.

24. The method according to claim 1, wherein said semiconductor substrate is formed of monocrystalline Si, monocrystalline Ge or monocrystalline SiGe, and the crystal orientation of the surfaces of the semiconductor substrate corresponding to the sidewalls of said first or second trench is {111}.

25. The method according to claim 24, wherein the crystal orientation of said first surface is {110} or {112}.

26. A thin-film solar cell structure, comprising:
a semiconductor strip plate having a first doping type, said semiconductor strip plate including a third surface and a fourth surface opposite thereto;
a first structure located on the third surface of said semiconductor strip plate, and a second structure located on the fourth surface, wherein said first structure, said second structure or a combination thereof constitutes a light entry surface of the solar cell structure; and
sidewall spacers located on both sides of said semiconductor strip plate.

27. The structure according to claim 26, wherein said first structure comprises: a first semiconductor layer and a first electrode layer, wherein said first semiconductor layer has a second doping type, which is opposite to the first doping type.

28. The structure according to claim 26, wherein said first structure comprises: a first intrinsic amorphous silicon layer (i-a-Si), a first semiconductor layer and a first electrode layer, wherein said first semiconductor layer has a second doping type, which is opposite to the first doping type.

29. The structure according to claim 26, wherein said second structure comprises a second electrode layer.

30. The structure according to claim 26, wherein said second structure comprises a second semiconductor layer and a second electrode layer having the first doping type.

31. The structure according to claim 26, wherein said second structure comprises a second intrinsic amorphous silicon layer (i-a-Si), a second semiconductor layer having the first doping type and a second electrode layer.

32. The structure according to claim 27 or 30, wherein said first and second semiconductor layers comprise one or more materials selected from a group consisting of amorphous silicon (a-Si), polycrystalline Si (poly-Si) and monocrystalline Si.

33. The structure according to claim 28 or 31, wherein said first and second semiconductor layers are formed of amorphous silicon (a-Si).

34. The structure according to claim 28 or 31, wherein the thickness of said first and second intrinsic amorphous silicon layers is about 1-10nm.

35. The structure according to claim 28 or 31, wherein the thickness of said first and second semiconductor layers is about 10-50nm.

36. The structure according to claim 26, wherein said sidewall spacers comprise an insulation layer.

37. The structure according to claim 26, wherein said sidewall spacers comprise an insulation layer and a conductive layer provided thereon, wherein said conductive layer is connected to a first or a second electrode layer.

38. The structure according to claim 37, wherein said conductive layer and the first or second electrode are formed as an integral structure.

39. The structure according to any one of claims 26 to 31, wherein said first and second electrodes are formed by TCO materials, wherein said TCO materials are selected from a group consisted of SnO₂, In₂O₃, ZnO, ITO, CdO, Cd₂SnO₄, FTO and AZO.

40. The structure according to claim 38, wherein said conductive layer, said first and second electrode layers are formed by TCO materials, wherein said TCO materials are selected from a group consisted of SnO₂, In₂O₃, ZnO, ITO, CdO, Cd₂SnO₄, FTO and AZO.

41. The structure according to claim 36 or 37, wherein said insulation layer is formed of one or more materials selected from a group consisted of silicon nitride, silicon oxide, silicon oxynitride, TiO₂, HfO₂, ZrO₂ and Al₂O₃.

42. The structure according to claim 26, wherein said semiconductor strip plate comprises one or more materials selected from a group consisting of monocrystalline Si, monocrystalline Ge, monocrystalline SiGe, polycrystalline Si, polycrystalline Ge, polycrystalline SiGe, III-V and II-VI compound semiconductor.

43. The structure according to claim 26, wherein said semiconductor strip plate is formed of monocrystalline Si, monocrystalline Ge, or monocrystalline SiGe, and the crystal orientation of the third surface of said semiconductor strip plate is {111}.

44. The structure according to claim 43, wherein the crystal orientation of the surface perpendicular to said third surface of said semiconductor strip plate is {110} or {112}.

45. The structure according to claim 26, wherein the thickness of said semiconductor strip plate is about 5-120µm, and the width of said semiconductor strip plate is about 0.2-3mm, wherein said thickness is measured between said third surface and said fourth surface of the same strip plate, and said width is measured between said two sidewall spacers of the same semiconductor strip plate.

46. A thin-film solar cell array, comprising a plurality of said thin-film solar cell structures of claims 26 to 45, wherein said thin-film solar cell structures are connected in parallel with each other.

47. A thin-film solar cell structure formed by the method of claims 1 to 25.

48. A thin-film solar cell array, comprising:
a plurality of thin-film solar cell structures, each said solar cell structures comprising: (a) a semiconductor strip plate having a first doping type, said semiconductor strip plate having a third surface and a fourth surface opposite thereto, (b) a first structure located on the third surface, and (c) a second structure located on the fourth surface, wherein said first structure comprises at least a first semiconductor layer having a second doping type and a first electrode layer, and wherein said second structure comprises at least a second electrode layer, said second doping type and said first doping type being opposite to each other, and said first structure, said second structure or combinations thereof constituting a light entry surface of said thin-film solar cell structure; and
a plurality of bendable insulation layers, respectively, formed on two opposing surfaces (other than said third and fourth surfaces) of neighboring strip plates and connected to said neighboring strip plates; and
a plurality of first conductive layers and second conductive layers matching said plurality of bendable insulation layers, wherein said first conductive layers and second conductive layers are located on the insulation layers, said first conductive layers are coupled to the first electrode layers of two neighboring thin-film solar cell structures, and said second conductive layers are coupled to the second electrode layers of two neighboring thin-film solar cell structures.

49. The array according to claim 48, wherein the curvatures of neighboring bendable insulation layers are opposite to each other.

50. The array according to claim 48, wherein said semiconductor strip plate and said first semiconductor layer form a p-n junction.

51. The array according to claim 48, wherein said first structure further comprises: a first intrinsic amorphous silicon layer (i-a-Si) located between said first semiconductor layer and said semiconductor strip plate.

52. The array according to claim 48, wherein said second structure further comprises: a second semiconductor layer located between said second electrode layer and said semiconductor strip plate, wherein said second semiconductor layer has the first doping type.

53. The array according to claim 48, wherein said second structure further comprises: a second intrinsic amorphous silicon layer (i-a-Si) located between said second semiconductor layer and said semiconductor strip plate.

54. The array according to claim 48, wherein said first and second semiconductor layers comprise one or more materials selected from a group consisting of amorphous silicon (a-Si), polycrystalline Si (poly-Si) and monocrystalline Si.

55. The array according to claim 51 or 53, wherein said first and second semiconductor layers are formed of amorphous silicon (a-Si).

56. The array according to claim 51 or 53, wherein the thickness of said first and second intrinsic amorphous silicon layers is about 1-10nm.

57. The array according to claim 51 or 53, wherein the thickness of said first and second semiconductor layers is about 10-50nm.

58. The array according to claim 48, wherein the materials of said bendable insulation layers are formed of one or more materials selected from a group consisted of silicon nitride, silicon oxide, silicon oxynitride, TiO₂, HfO₂, ZrO₂ and Al₂O₃.

59. The array according to claim 48, wherein said first and second electrodes are formed by TCO materials, wherein said TCO materials are selected from a group consisted of SnO₂, In₂O₃, ZnO, ITO, CdO, Cd₂SnO₄, FTO and AZO.

60. The array according to claim 48, wherein said first conductive layer and said first electrode layer are formed as an integral structure.

61. The array according to claim 48, wherein said second conductive layer and said second electrode layer are formed as an integral structure.

62. The array according to claim 60 or 61, wherein said first and second conductive layers are formed by TCO materials, wherein said TCO materials are selected from a group consisted of SnO₂, In₂O₃, ZnO, ITO, CdO, Cd₂SnO₄, FTO and AZO.

63. The array according to claim 48, wherein said semiconductor strip plate comprises one or more materials selected from a group consisting of monocrystalline Si, monocrystalline Ge, monocrystalline SiGe, polycrystalline Si, polycrystalline Ge, polycrystalline SiGe, III-V and II-VI compound semiconductor.

64. The array according to claim 48, wherein said semiconductor strip plate is formed of monocrystalline Si, monocrystalline Ge or monocrystalline SiGe, and the crystal orientation of the third surface of said semiconductor strip plate is {111}.

65. The array according to claim 64, wherein the crystal orientation of the surface perpendicular to the third surface of said semiconductor strip plate is {110} or {112}.

66. The array according to claim 48, wherein the thickness of said semiconductor strip plate is about 5-120µm, and the width thereof is about 0.2-3mm, wherein said thickness is the distance between said third surface and said fourth surface, and said width is the distance between the inner sides of two said bendable insulation layers of said semiconductor strip plate.

67. The array according to claim 48, wherein said plurality of thin-film solar cell structures are provided on planes parallel with said third surface.
